# EUROPEAN PATENT APPLICATION

(11) **EP 2 224 199 A1**
(43) Date of publication of application: **01.09.2010**
(21) Application number: 10152537.6
(22) Date of filing: 03.02.2010
(51) Int. Cl.: F28F 3/02, F28F 3/06, H01L 23/367, H01L 23/467

(54) **Heat sink with forced ventilation, particularly for high-power electronic devices**

(30) Priority: 24.02.2009 IT MI20090251
(71) Applicant: DMT Systems S.p.A. Ovvero Dmts S.p.A., 20035 Lissone (MI) (IT)
(72) Inventor: Carcano, Marco, 20030 Senago (Prov. of Milano) (IT); Dalla Longa, Bruno, 20038 Seregno (Prov. of Monza Brianza) (IT)
(74) Representative: Modiano, Micaela Nadia

(57) **Abstract**

A heat sink (1) with forced ventilation, particularly for high-power electronic devices comprises a dissipation plane (2) which can be connected thermally to an electronic device (9) to be cooled and is jointly connected to a plurality of cooling fins (3) which protrude substantially at right angles from the dissipation plane (2) and define a plurality of ducts (6) for the passage of forced air in order to conduct the forced air and cool the cooling fins (3), the passage ducts (6) are arranged in a grid and run substantially parallel to the dissipation plane (2).

## Description

The present invention relates to a heat sink with forced ventilation, particularly for high-power electronic devices.

Heat sinks provided in several shapes and with several production processes are currently used commercially to cool high-power electronic devices, such as for example radio frequency power transistors, also known as RF, used to broadcast analog and/or digital television signals in the VHF and UHF frequency ranges.

Among such known devices it is possible to find, for example, heat sinks obtained by extrusion, which consist of finned bodies obtained by drawing aluminum through a die and which are used with natural convection and with forced ventilation.

These known types of heat sinks can achieve good thermal efficiencies as the surface over which the air flows increases. In theory, this increase can be achieved by enlarging the heat sink proper or by increasing the packing of the heat exchange fins.

However, this increase in the packing of the heat exchange fins is not possible beyond a maximum limit, since the production technology used to provide such heat sinks does not make it possible to obtain dies with densely packed fins.

The alternative of increasing the dimensions therefore remains but is scarcely advantageous, since it leads to a heat sink that is much larger than the electronic device to be cooled.

Another example of known types of heat sinks can consist in heat sinks obtained from fins arranged side by side.

This second type of known heat sinks is constituted by drawn aluminum fins, whose base has a particular geometry, such that they can be arranged side by side and pressed or, as an alternative, interlocked and/or bonded with adhesive. In this manner, heat sinks are obtained which have dimensions that are multiples of the initial element; of course, the thickness of the plane or surface, the spacing and the length of the fins depend on the dimensions of the base element.

Since heat transfer from the flat part to the fin is optimum only for a few centimeters, the best efficiency of this solution is achieved if the power to be dissipated is distributed over two flat parts which are mutually opposite and share the same fins, so as to form a single ventilation duct.

A last example of known types of heat sinks are heat sinks with perpendicular ventilation. This type of heat sink can be made of aluminum by extrusion, by casting or by milling and by using different materials. In the more challenging cases, they are made of copper.

In this type of solution, the air flow strikes the heat sink at right angles, leading to optimum cooling.

However, if the heat source is located within an apparatus, further ventilation is necessary in order to extract the air, drastically limiting space optimization.

The aim of the present invention is to provide a heat sink with forced ventilation, particularly for high-power electronic devices, that makes it possible to cool effectively the electronic devices to which it is attached, with less space occupation than in the background art.

Within this aim, an object of the present invention is to provide a heat sink that is easy to manufacture.

Another object of the present invention is to provide a heat sink that has a simple structure and relatively low costs.

This aim and these and other objects that will become better apparent hereinafter are achieved by a heat sink with forced ventilation, particularly for high-power electronic devices, comprising a dissipation plane which can be connected thermally to an electronic device to be cooled and is jointly connected to a plurality of cooling fins which protrude substantially at right angles from said dissipation plane and form a plurality of ducts for the passage of forced air in order to conduct said forced air and cool said cooling fins, **characterized in that** said passage ducts are arranged in a grid and run substantially parallel to said dissipation plane.

Further characteristics and advantages of the present invention will become apparent from the description of a preferred but not exclusive embodiment of a heat sink with forced ventilation particularly for high-power electronic devices, according to the invention, illustrated by way of non-limiting example in the accompanying drawings, wherein:

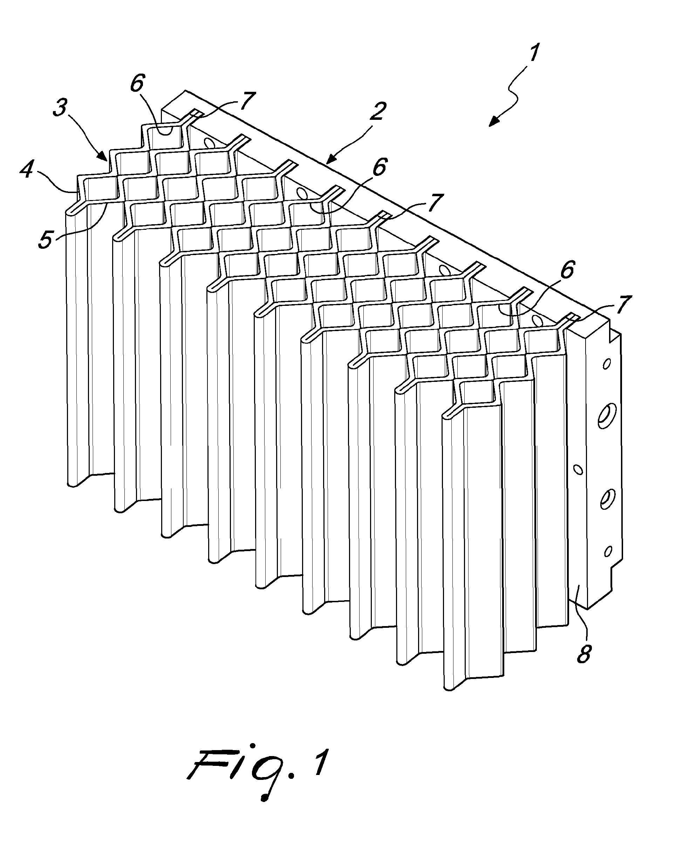

Figure 1 is a perspective view of a heat sink with forced ventilation, particularly for high-power electronic devices, according to the invention;

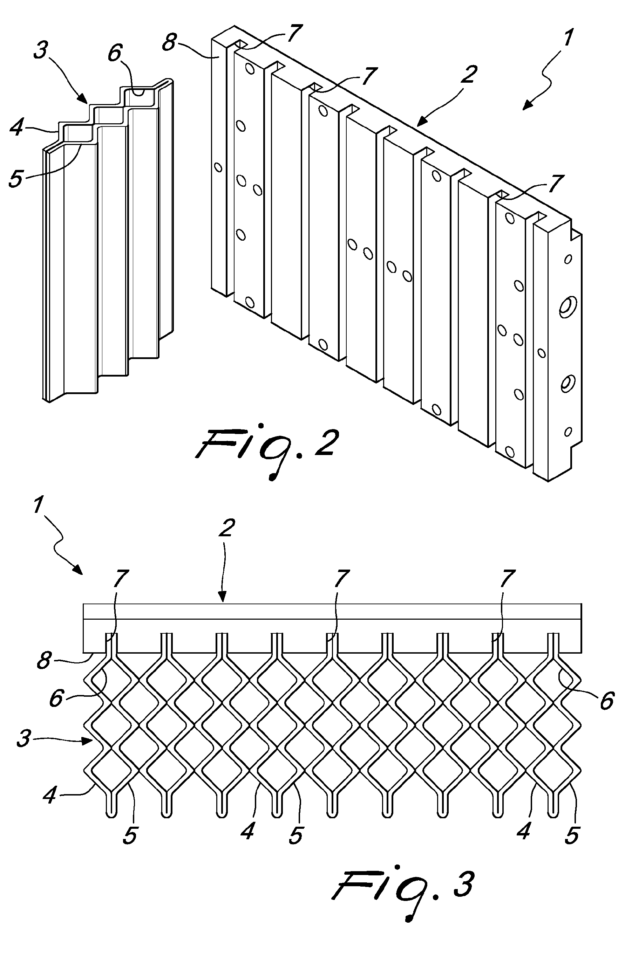

Figure 2 is an exploded perspective view of the heat sink shown in Figure 1;
Figure 3 is a front elevation view of the heat sink shown in Figure 1;
Figure 4 is a perspective view of an electronic device with high-power transistors to which two heat sinks according to the invention are applied.

With reference to the figures, the heat sink with forced ventilation, particularly for high-power electronic devices, generally designated by the reference numeral 1, comprises a dissipation plane 2, which is made of a material with high heat conductivity, for example aluminum, copper, graphite and graphite fibers, which can be thermally connected to an electronic device 9 to be cooled and is jointly connected to a plurality of cooling fins 3, also made of a material with high heat conductivity, for example aluminum, copper, graphite and graphite fibers, and protruding substantially at right angles from the dissipation plane 2.

Advantageously, each one of the cooling fins 3 comprises a metal sheet which is folded by plastic deformation along its own axis of symmetry and forms two mutually facing lateral portions 4 and 5 which are symmetrically undulated to define a plurality of ducts 6 for the passage of forced air in order to conduct said air and cool the cooling fins 3.

In this manner it is possible to provide a very large surface which faces the air in transit, optimizing the flow of such air in transit in the individual duct 6, so that heat exchange with the cooling fins 3 is facilitated.

More precisely, the dissipation plane 2 comprises a plurality of mutually parallel slots 7 defined on the surface 8 that faces the cooling fins 3 in order to fix them to the dissipation plane 2.

The cooling fins 3 are in fact fixed to the dissipation plane 2 by insertion by pressing them into the slots 7, with subsequent welding between the cooling fins 3 and the dissipation plane 2.

As an alternative, the cooling fins 3 can be provided by extrusion both in the case of a single fin and in the case of multiple fins, maintaining the described geometry.

In the case of a single cooling fin 3, each cooling fin 3 in fact has a triangular undulation in order to define the passage ducts 6 having a rhomboid cross-section.

Likewise, in the case of a plurality of cooling fins 3, such fins comprise the lateral portions 4 and 5 that face each other and are symmetrically undulated to define the passage ducts 6 having a rhomboid cross-section.

According to the invention, the passage ducts 6 are arranged in a grid according to a quincuncial arrangement and lie substantially parallel to the dissipation plane 2.

More particularly, the lateral portions 4 and 5 of the cooling fins 3 have a triangular undulation, so that the passage ducts 6 assume a rhomboid cross-section.

As an alternative, the cooling fins 3 can assume different shapes, so as to create passage ducts 6 whose shape is for example circular or polygonal.

The particular geometry of the cooling fins 3 makes it possible to facilitate maximum transfer of heat between the generic cooling fin 3 and the air in transit, thanks to an optimum air drag, which is not too low, which would reduce the efficiency of the heat sink 1, and not too high, which would slow down the air excessively, limiting the volume in transit and therefore limiting the ability to remove heat.

In this regard, experimental tests show that the optimum size of the cooling fins 3 is such as to form passage ducts 6 which have a square cross-section whose diagonal is comprised between 5.6 mm and 11.3 mm and is preferably equal to 8.6 mm.

Operation of the heat sink 1 according to the present invention is directly derivable from what has been described above.

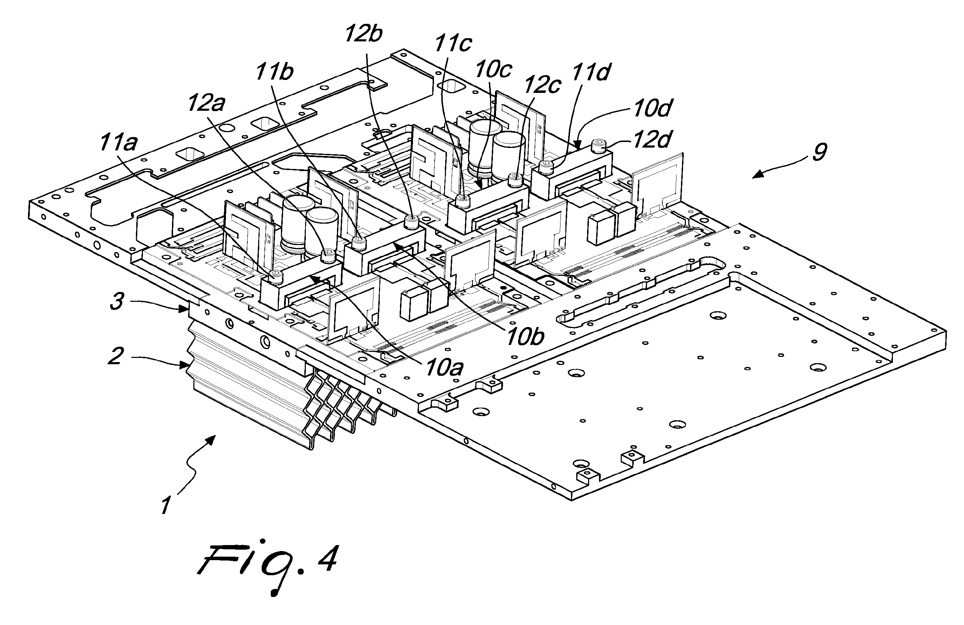

With reference to Figure 4, for better understanding of the benefits introduced by the heat sink 1 with respect to the background art, a comparative test is presented hereafter comparing a heat sink 1 according to the invention and a conventional heat sink obtained through side-by-side fins.

The measurements were performed with direct current, simulating the maximum power dissipated by the four transistors 10a, 10b, 10c and 10d of the electronic device 9 under real operating conditions at radio frequency, using respectively a heat sink with side-by-side fins provided with a copper insert for maximizing its heat exchange efficiency and a heat sink 1 according to the present invention.

The measurements given hereinafter refer to the temperatures detected on the pairs of screws 11a, 12a, 11b, 12b, 11c, 12c, 11d and 12d, which respectively clamp the flanges of the four RF Freescale MRFE6P3300H transistors 10a, 10b, 10c and 10d, powered at 32 V and with a bias current of 6.5 A (208 W).

The first table refers to a heat sink according to the background art, which consists of a PADA aluminum heat sink W = 200 mm x L = 160 mm x H = 43.6 mm (where W is the width of the air intake front, L is the length of the heat sink, H is the height of the air intake front) with a flat dissipation part having a thickness of 13 mm (for increasing efficiency, a 50 x 5 x 200 mm copper bar is inserted by milling below the transistors, at the center of the flat part) and fins measuring 1.5 x 30.6 mm with a spacing of 6 mm at an ambient temperature of +25°C and with an air flow of 400 m³/h.

**TABLE 1**

| | **Screw 11a, 11b, 11c, 11d** | **Screw 12a, 12b, 12c, 12d** | **Average temp. of transistor screws** |
|---|---|---|---|
| Transistor 10a | +83.5°C | +80.0°C | +81.8°C |
| Transistor 10b | +87.0°C | +85.0°C | +86.0°C |
| Transistor 10c | +88.5°C | +90.0°C | +89.3°C |
| Transistor 10d | +86.5°C | +86.0°C | +86.3°C |

The second table instead refers to a heat sink according to the present invention, which consists of two heat sinks 1 made of copper and arranged side-by-side, W = 200 mm x L = 65 mm x H = 43.6 mm (where W is the width of the air intake front, L is the length of the heat sink, H is the height of the air intake front) at an ambient temperature of +25°C and with an air flow of 240 m³/h.

**TABLE 2**

| | **Screw 11a, 11b, 11c, 11d** | **Screw 12a, 12b, 12c, 12d** | **Average temp. of transistor screws** |
|---|---|---|---|
| Transistor 10a | +78.2°C | +77.6°C | +77.9°C |
| Transistor 10b | +79.3°C | +80.9°C | +80.1°C |
| Transistor 10c | +82.4°C | +79.7°C | +81.1°C |
| Transistor 10d | +77.7°C | +80.9°C | +79.3°C |

A table which summarizes the advantages introduced by the heat sink 1 according to the invention with respect to the background art is provided hereinafter.

**TABLE 3**

| | **Background art** | **Heat sink 1** | **Difference** |
|---|---|---|---|
| Air flow | 400 m³/h | 240 m³/h | -40% |
| Average ambient/screw temperature variation | +60.8°C | +54.6°C | -10% |
| Used heat sink volume | 1395 cm³ | 567 cm³ | -59% |

The above tables clearly show that the heat sink according to the invention leads to a thermal variation between the average temperature of the screws of the generic transistor 10a, 10b, 10c, and 10d and the ambient temperature, typically equal to 25°C, that is lower by at least 6°C, i.e., 10% lower, than the background art.

In practice it has been found that the heat sink with forced ventilation particularly for high-power electronic devices, according to the present invention, fully achieves the intended aim and objects, since it allows optimum cooling of the electronic devices to which it is connected, with reduced space occupation with respect to the background art and with a saving in air flow-rate.

Another advantage of the heat sink according to the present invention is that it is simple in construction and technologically obtainable at competitive costs.

The heat sink with forced ventilation particularly for high-power electronic devices according to the present invention is susceptible of numerous modifications and variations, all of which are within the scope of the appended claims.

All the details may further be replaced with other technically equivalent elements.

In practice, the materials used, as long as they are compatible with the specific use, as well as the contingent shapes and dimensions, may be any according to requirements and to the state of the art.

The disclosures in Italian Patent Application No. MI2009A000251 from which this application claims priority are incorporated herein by reference.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A heat sink with forced ventilation, particularly for high-power electronic devices, comprising a dissipation plane (2) which can be connected thermally to an electronic device (9) to be cooled and is jointly connected to a plurality of cooling fins (3) which protrude substantially at right angles from said dissipation plane (2) and form a plurality of ducts (6) for the passage of forced air in order to conduct said forced air and cool said cooling fins (3), **characterized in that** said passage ducts (6) are arranged in a grid and run substantially parallel to said dissipation plane (2).

2. The heat sink according to claim 1, **characterized in that** said passage ducts (6) have a quincuncial arrangement.

3. The heat sink according to one or more of the preceding claims, **characterized in that** each one of said cooling fins (3) comprises a metal sheet which is folded by plastic deformation along its own axis of symmetry and defines two lateral portions (4, 5) which face each other and are symmetrically undulated to form said passage ducts (6).

4. The heat sink according to one or more of the preceding claims 1 and 2, **characterized in that** each one of said cooling fins (3) is provided by extrusion and has a triangular undulation in order to define said passage ducts (6) having a rhomboid cross-section.

5. The heat sink according to one or more of the preceding claims 1 and 2, **characterized in that** said cooling fins (3) are provided by extrusion and define two lateral portions (4, 5) which face each other and are symmetrically undulated in order to define said passage ducts (6).

6. The heat sink according to one or more of the preceding claims 3 or 5, **characterized in that** said lateral portions (4, 5) have a triangular undulation in order to define said passage ducts (6) having a rhomboid cross-section.

7. The heat sink according to one or more of the preceding claims 4 or 6, **characterized in that** said passage ducts (6) have a square cross-section with a diagonal comprised between 5.6 mm and 11.3 mm and preferably equal to 8.6 mm.

8. The heat sink according to claim 7, **characterized in that** said dissipation plane (2) comprises a plurality of mutually parallel slots (7) defined on the surface (8) that faces said cooling fins (3) in order to fix said fins to said dissipation plane (2).

9. The heat sink according to one or more of the preceding claims 7 and 8, **characterized in that** said cooling fins (3) are fixed to said dissipation plane (2) by insertion by pressing of said cooling fins (3) into said slots (7).

10. The heat sink according to one or more of the preceding claims 7 to 9, **characterized in that** said cooling fins (3) are welded to said dissipation plane (2).

11. The heat sink according to one or more of the preceding claims 7 to 10, **characterized in that** said cooling fins (3) are made of a material with high heat conductivity comprised among aluminum, copper, graphite and graphite fibers.

12. The heat sink according to one or more of the preceding claims 7 to 11, **characterized in that** said dissipation plane (2) is made of a material with high heat conductivity comprised among aluminum, copper, graphite and graphite fibers.
